# EUROPEAN PATENT SPECIFICATION

(11) **EP 1 807 710 B1**
(45) Date of publication and mention of the grant of the patent: **20.01.2010**
(21) Application number: 05807242.2
(22) Date of filing: 02.11.2005
(51) Int. Cl.: G01R 31/36, H01R 4/30

(54) **KELVIN CONNECTOR INCLUDING TEMPERATURE SENSOR**
KELVIN-VERBINDUNGSSTECKER MIT TEMPERATURSENSOR
CAPTEUR DE TEMPERATURE INCLUANT UN CONNECTEUR DE KELVIN

(30) Priority: 03.11.2004 GB 0424333
(43) Date of publication of application: 18.07.2007
(73) Proprietor: LIAISONS ELECTRONIQUES-MECANIQUES LEM S.A., 1228 Plan-les-Ouates (CH)
(72) Inventor: SCOTT, Nigel David, Wilmslow, Cheshire SK9 5PW (GB)
(74) Representative: Reuteler, Raymond Werner
(86) International application number: PCT/GB2005/004209
(87) International publication number: WO 2006/048625

(56) References cited:
- WO-A-99/54744
- DE-A- 3 532 044
- US-A1- 2003 092 308
- US-A1- 2003 124 417

## Description

### Field of the Invention

The present invention relates to battery measuring apparatus, an assembly comprising battery measuring apparatus and a battery, a Kelvin connector including a temperature sensor, an assembly comprising a Kelvin connector including a temperature sensor and a battery and a method of measuring the temperature of a battery.

### Background to the Invention

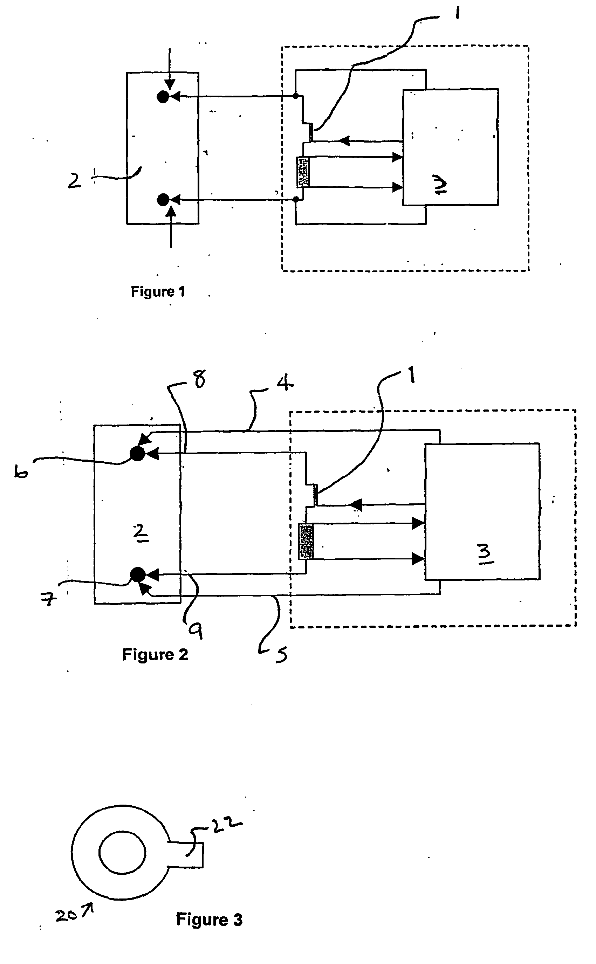

When undertaking AC impedance measurement of electrochemical cells, the cell may be perturbed by injecting or drawing a current in an oscillating pattern or frequency, through the cell. The example, in Figure 1 shows measurement apparatus 3 incorporating a transistor 1 to "short" the cell 2 in a current controlled manner.

One of the problems encountered when using this method is that, due to the very low impedances of the cells 2, the values of voltage response measured can be very small or minute.

In this case, measurement of the voltage response cannot be undertaken using the same connector to the cell/battery as the one that carries the test current, since the test current, due to the connection resistance, will create a voltage drop across the connection and this will be measured by the sense electrode in addition to the cell voltage response.

This connection resistance can be higher that the internal impedance of the cell and therefore the cell voltage response measurement will be distorted.

If, for example, the cell impedance is 200 micro-Ohms and the connection resistance in the order of 1 milli-Ohm, any change in the cell impedance will be reduced, as a function of the total measurement, by 5:1. This will significantly reduce the ability of the measurement system 3 to detect key changes in cell impedance.

It is therefore necessary to connect the current and sense leads using two different connectors 4, 5, each of which must contact the cell termination post 6, 7 directly, thus giving four separate connections per current control and measurement system, as shown in Figure 2.

Most batteries for standby use are manufactured with contacts, for example, with 6 to 12 mm studs, or lugs through which a bolt may be fitted, for connection of the load carrying cables/straps to the battery posts.

Standard ring-tab washers, sometimes called spade terminal washers 20, or LUCAR connectors 20 can be procured for this type of connection as shown in Figure 3.

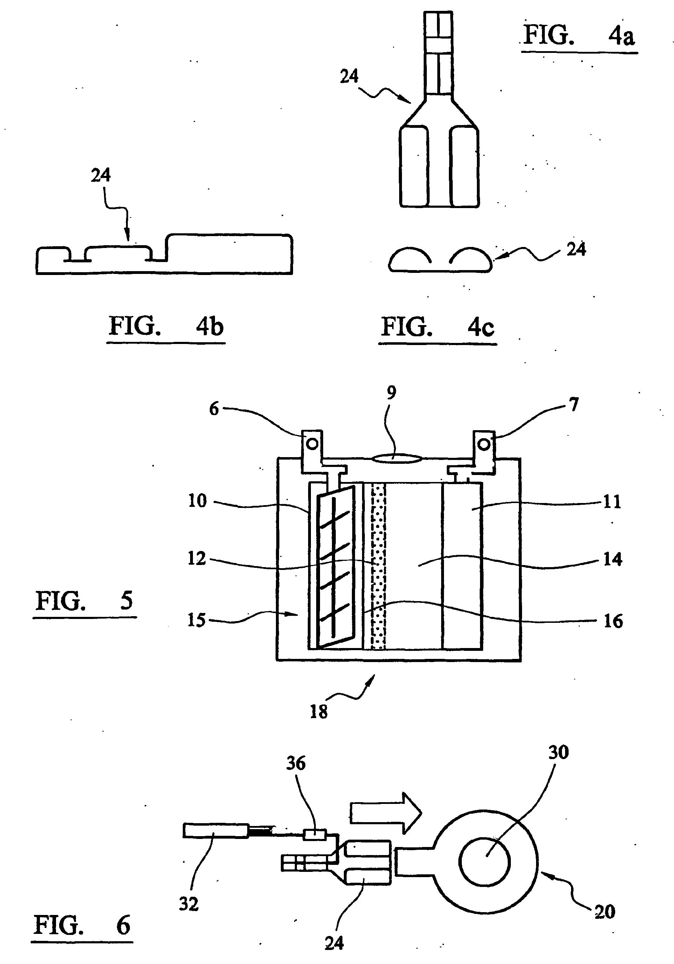

It is normal for continuous battery monitoring systems to be connected to these tab washers 20, so that the cell or battery may be monitored for failure conditions. The connector 24, which connects the current and sense wires to these tab washers, is, for example, a push-fit type as shown in Figure 4.

Furthermore, it is desirable to know the temperature of the cell 2 as accurately as possible, since many failure modes in service manifest raised cell temperature as a symptom.

However, measuring the internal temperature of a battery 2 is difficult in the field; since the external temperature of the base, due to its insulating properties, may be several degrees higher than the internal temperature of the plates, etc.

It would therefore be more effective to measure the post temperature or temperature of the cell termination posts 6, 7, since these are thermally connected to the internal metalwork of the cell 2.

Figure 5 shows an example of the construction of a Valve Regulated Lead-Acid (VRLA) cell 18. It can be seen that the terminal post 6, 7 (lug) is in direct thermal contact with the positive and negative plates 10, 11. The cell 18 comprises positive and negative group bars, positive and negative plates, a spun glass separator 14 containing electrolyte and a gassing and chemical recombination space 15.

Other prior instruments have used temperature measuring devices in contact with the cell post, using dedicated wires or leads additional to the existing Kelvin leads. However, this may result in several (for example, three or four) connectors 24 being attached to several corresponding washers 20 on each contact of the battery. This is not possible in certain circumstances and particularly when the cell termination posts 6, 7 are relatively small or where access to the posts 6, 7 is limited or restricted. Alternatively, the numerous connections may not be electrically or thermally good which may result in poor or inaccurate measurements.

It is an aim of the present invention to overcome at least one problem associated with the prior art whether referred to herein or otherwise.

WO 99/54744 discloses a battery measuring terminal connected to a positive terminal pole of a rechargeable battery in both a thermally and electrically conductive manner.

DE 35 32 044 discloses a battery terminal clamp for fixing to a conventional battery terminal pole, in which a Hall element and evaluation electronic circuit is incorporated for measuring electrical current.

US 2003/0092308 discloses a Kelvin connector for coupling to a post of a battery.

US 2003/124417 discloses a battery test module mounted to a battery housing of a storage battery and electrically coupled to the terminals of the battery through Kelvin connections. A temperature sensor may be thermally coupled to the battery through an additional connector.

### Summary of the Invention

According to a first aspect of the present invention there is provided battery measuring apparatus comprising temperature sensing means and electrical measuring means wherein the apparatus comprise a first connection means which is arranged, in use, to connect both the temperature sensing means and the electrical measuring means to a first contact of the battery and the apparatus comprises a second connection means which is arranged, in use, to connect the electrical measuring means to a second contact of the battery.

Preferably the first connection means comprise a first Kelvin connector. Preferably the second connection means comprises a second Kelvin connector.

Preferably the temperature sensing means is connected using a lead of the electrical testing means.

Preferably the temperature sensing means comprises temperature measuring means.

Preferably the electrical measuring means is arranged to measure an electrical parameter of the battery. The electrical measuring means may measure the impedance and/or current and/or voltage of the battery.

Preferably the first connection means comprises a single ended connector.

The first connection means may comprise a first connector and a second connector each relating to a respective first connection lead and a second connection lead. The first connector may comprise a first push fit connector and the second connector may comprise a second push fit connector. The first push fit connector may be arranged, in use, to be secured to a first tab provided on a first contact of the battery and the second push fit connector may be arranged, in use, to be secured to a second tab provided on a first contact of the battery.

The first tab may be provided on a first washer and the second tab may be provided on a second washer.

The first tab and the second tab may be provided on a single washer.

Preferably the first connection means comprise a single ended connector.

The second connection means may comprise a first connector and a second connector each relating to a respective first connection lead and a second connection lead. The first connector may comprise a first push fit connector and the second connector may comprise a second push fit connector.

The first push fit connector may be arranged, in use, to be secured to a first tab provided on a second contact of the battery and the second push fit connector may be arranged, in use, to be secured to a second tab provided on a second contact of the battery.

The first tab may be provided on a first washer and the second tab may be provided on a second washer.

The first tab and the second tab may be provided on a single washer.

Preferably the first connection means comprise a single ended connector.

Preferably the temperature sensing means is arranged, in use, to be in thermal contact (or communication, for example through conduction) with a first contact of the battery.

Preferably the temperature sensing means is arranged to indicate or measure the internal temperature of the battery and preferably the core temperature of the battery.

Preferably the temperature sensing means comprises a thermistor.

Preferably the first connection means incorporates the thermistor.

The first connection means may comprise a push fit connector. The connection means may comprise a first push fit connector and a second push fit connector.

The second connection means may comprise a push fit connector. The second connection means may comprise a first push fit connector and a second push fit connector.

The or each contact of the battery may comprise a washer and preferably comprises a tab washer. The or each contact of the battery may comprise a first tab washer and a second tab washer.

Each (both) contact of the battery may comprise a first tab and a second tab in order for a first connector and a second connector to be secured to each (both) contact of the battery.

Preferably the first connection means comprises a first connection lead and a second connection lead. The first connection lead may comprise a sense lead. The second connection lead may comprise a current lead.

Preferably the thermistor is located in series along the first connection lead (the sense lead) of the first connection means.

The first connection lead of the first connection means may be arranged, in use, to be connected to the first tab washer of a first contact of the battery and the second connection lead of the first connection means may be arranged, in use, to be connected to the second tab washer of a first contact of the battery.

The first connection lead of the second connection means may be arranged, in use, to be connected to the first tab washer of a second contact of the battery and the second connection lead of the second connection means may be arranged, in use, to be connected to the second tab washer of a second contact of the battery.

Preferably the second connection means comprises a first connection lead and a second connection lead.

The first connection lead may comprise a sense lead. The second connection lead may comprise a current lead.

Preferably the or each current lead applies a current to the respective contact of the battery.

The second connection means may incorporate second temperature sensing means. The second temperature sensing means may comprise a second thermistor.

Preferably the second thermistor locates in series along the first connection lead (the sense lead) of the second connection means.

The battery measuring apparatus may be arranged to continuously measure an electrical parameter or characteristic of the battery and may be arranged to continuously sense and/or measure the temperature of the battery.

According to a second aspect of the present invention there is provided an assembly comprising battery measuring apparatus and a battery, the battery measuring apparatus comprising temperature sensing means and electrical measuring means wherein the apparatus comprise a first connection means which is arranged, in use, to connect both the temperature sensing means and the electrical measuring means to a first contact of the battery and the apparatus comprises a second connection means which is arranged, in use, to connect the electrical measuring means to a second contact of the battery.

The battery may comprise a cell or may comprise a monobloc.

According to a third aspect of the present invention there is provided a method of measuring the temperature of a battery comprising securing electrical measuring apparatus to a contact of the battery and measuring the temperature of the battery and wherein the measuring apparatus comprises temperature sensing means and electrical measuring means.

Preferably the method simultaneously measures the temperature and an electrical parameter or characteristic of the battery. The method may comprise measuring the impedance and/or current and/or voltage of the battery.

Preferably the method comprises locating a temperature sensor of the temperature sensing means in thermal communication with the battery and more preferably in thermal communication within an internal part of the battery.

The method may comprise securing a first connector to a first contact of the battery and may comprise securing a second connector to a second contact of the battery.

The method may comprise securing a first connector and a second connector to a first contact of the battery and may comprise securing a third connector and a fourth connector to a second contact of the battery.

The method may comprise connecting only two leads to a first contact of the battery and only two leads to a second contact of the battery in order to measure both the temperature of the battery and en electrical measurement of the battery.

According to a fourth aspect of the present invention there is provided a Kelvin connector comprising temperature sensing means, the Kelvin connector comprising a sense lead and a current lead and connection means to connect the Kelvin connector to a contact of a battery wherein the temperature sensing means is connected along a lead of the Kelvin connector.

Preferably, when the Kelvin connector is connected to the battery contact, the temperature sensing means is arranged to measure the temperature of the battery and more preferably indicate or measure the internal temperature of the battery.

The temperature sensing means may comprises a thermistor.

Preferably the thermistor is connected to the sense lead. Preferably the thermistor is connected in series along the sense lead.

According to a fifth aspect of the present invention there is provided an assembly comprising a Kelvin connector and a battery, the Kelvin connector comprising temperature sensing means, the Kelvin connector further comprising a sense lead and a current lead and connection means to connect the Kelvin connector to a contact of a battery wherein the temperature sensing means is connected along a lead of the Kelvin connector.

According to a sixth aspect of the present invention there is provided a method of measuring the temperature of a battery comprising securing a Kelvin connector to a contact of the battery wherein the Kelvin connector includes temperature sensing means.

Preferably the temperature sensing means is located internally in the Kelvin connector.

Preferably the temperature sensing means is connected using a lead of the Kelvin connector.

Preferably the method comprises thermally connecting the temperature sensing means to a contact of the battery.

### Brief Description of the Drawings

The present invention will now be described, by way of example only, with reference to the drawings that follow, in which:
Figure 1 is a schematic diagram of prior art electrical measuring apparatus.
Figure 2 is a schematic diagram of prior art electrical testing apparatus.
Figure 3 is a plan view of an embodiment of a washer.
Figure 4a is a plan view of a connector.
Figure 4b is a side view of a connector.
Figure 4c is a front view of a connector.
Figure 5 is a schematic cross-section of a battery.
Figure 6 is a plan view of a part of a preferred embodiment of a Kelvin connector including a temperature sensor.
Figure 7 is a side view of a part of a preferred embodiment of a Kelvin connector including a temperature sensor.
Figure 8 is a schematic diagram of a part of preferred embodiment of a Kelvin connector including a temperature sensor.
Figure 9 is a schematic diagram of a preferred embodiment of combined electrical measuring and temperature sensing apparatus.
Figure 10 is a schematic diagram of another embodiment of combined electrical measuring and temperature sensing apparatus.
Figure 11 is a schematic view of an embodiment of part of first connection means of battery measuring apparatus.
Figure 12 is a schematic view of an alternative embodiment of a washer.

### Description of the Preferred Embodiments

During alternating current (AC) impedance measurement of electrochemical cells, the cell may be effected and, in particular, may be perturbed by applying (or injecting) or drawing a current in an oscillating pattern or frequency through the battery. As shown in Figure 1, a test instrument or system, uses a transistor to "short" the cell in a current controlled manner. The test instrument comprises a first connector which connects to a first terminal of an electrochemical cell and a second connector which connects to a second terminal. The term "battery" is interpreted and used to include all references to cells, batteries and monoblocs etc.

In many cases it would be inconvenient to utilise additional wires to connect a temperature sensitive device to the post, since this would necessitate having a separate connector at both the battery and the measuring device/instrument.

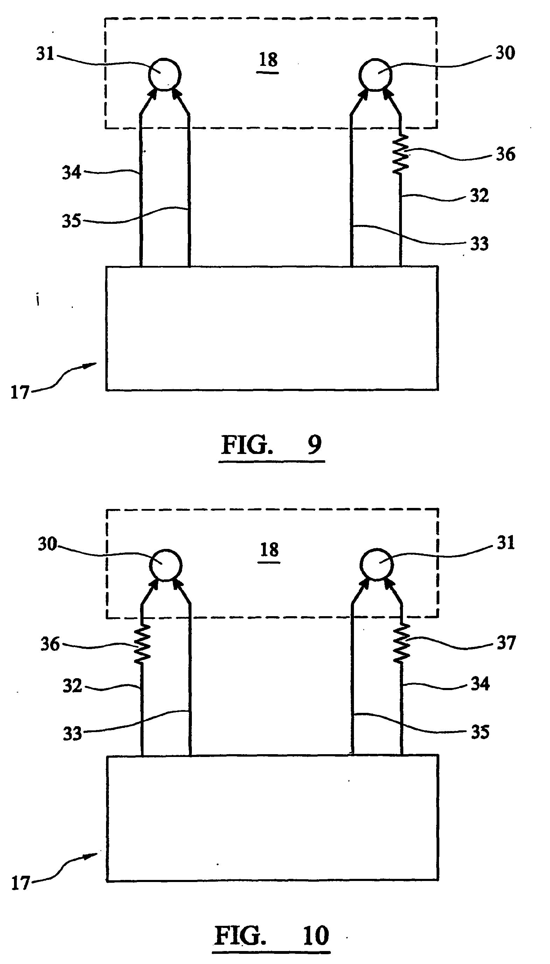

Briefly, as shown in Figure 9, the present invention comprises combined electrical measuring apparatus 17 and temperature sensing apparatus wherein the number of connections required to each contract 30, 31 of the battery 18 (or cell etc) is minimised. The present invention measures the core temperature of the battery 18 which may be useful in monitoring the health of the battery. Prior art apparatus measures the temperature of the outside of the battery. However, the outside of the case will be at a lower temperature than the core because of the thermal insulation properties of the case material. The outside temperature becomes an equilibrium between the core temperature and the ambient temperature. Furthermore, the case material is likely to introduce time delays before an equilibrium is reached and the measurements can be made.

The apparatus comprises first connection means to connect to the first contact 30 of the battery 18 and second connection means to connect to the second contact 31 of the battery 18. Each connection means comprises a first lead 32, 34 and a second lead 33, 35 in order to measure an electrical parameter of the battery 18. The apparatus 17 includes temperature sensing means, and in particular a thermistor 36, which connects in series with one lead 32 of the connecting means in order for the temperature of the battery 18 to also be measured. Accordingly, the present invention does not require the temperature sensor to be independently connected to the battery 18. The present invention only requires four measurement leads 32, 33, 34, 35 together with two or four associated connectors as will be described in more detail.

More particularly, the present invention comprises impedance measurement means and temperature sensing means in order to measure both the temperature and impedance of a battery 18 or cell, monobloc etc. The apparatus 17 includes a first connection means in the form of a first Kelvin connector and a second connection means in the form of a second Kelvin connector. The apparatus 17 does not include any further leads or connectors. As previously mentioned, prior art apparatus needs leads for connecting a temperature sensor and separate leads for connecting the electrical test apparatus to each post or terminal 30, 32 of a battery 18.

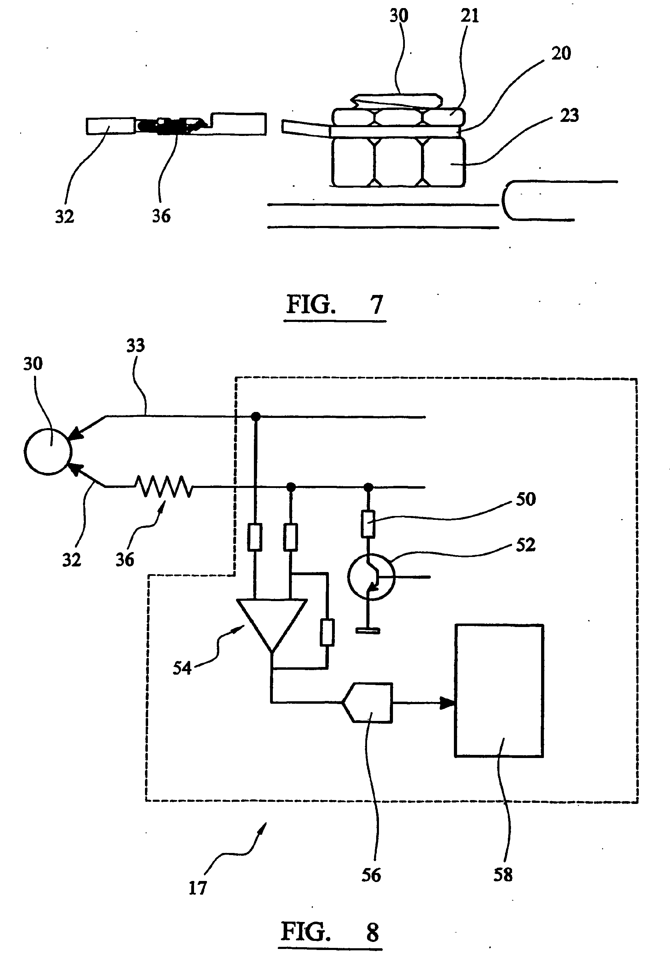

As shown in Figure 6 and Figure 7, the first connection means comprises a first push fit connector 24 (as shown in Figures 4a, 4b and 4c) in order to be simply and quickly connected to a tab 22 located on a first terminal 30 of the battery 18. The push fit connector 24 comprises a channel into which a lug or tab 22 of the tab washer 20 inserts in order to provide both a good electrical and thermal connection between the Kelvin connector and the post or terminal 30. The connector is arranged to secure the sense lead 32 to the contact 30 of the tab washer 20 located between a first nut 23 and a second nut 21 which are located on a threaded shaft or part of the contact 30. As can be seen from Figure 7, there is little room or space for numerous washers to be individually secured to the contact 30.

The first connection means also comprises a second push fit connector 24 in order to simply and quickly connect a second lead 34 of the Kelvin connector to the first terminal 30 of the battery 18.Accordingly, the first terminal of the battery 18 has a first tab washer and a second tab washer located thereon.

The first push fit connector 24 is connected by a wire, or a section of lead 32, to temperature sensing means in the form of a thermistor 36. The thermistor 36 is connected in series with the connecting lead 32, as shown in Figure 8 and Figure 9.

The second Kelvin connector is identical to the first Kelvin connector apart from the thermistor which is only provided on the first Kelvin connector.

As shown in Figure 7, only a single connection is required at the battery post or terminal 30, 32 in order for both the temperature and impedance of the battery 17 to be measured. It is appreciated that this single connection may comprise a first connector 24 and a second connector 24. In prior art apparatus, any temperature sensor required separate leads in order for the temperature sensor to be independently connected to the battery post or terminal 30, 32. This may require the use of three tab washers on a single terminal. These three separate connectors to a single terminal can be manually difficult to achieve, especially in relatively confined areas, and also may result in poor connection being made which may lead to measurement errors or inaccuracies.

As shown in Figure 8 and Figure 9, the first Kelvin connector includes a connecting lead comprising a current lead 33 and a sense lead 32. Similarly, the second Kelvin connector includes a connecting lead comprising a current lead 35 and a sense lead 34. Accordingly, the apparatus comprises four wire Kelvin testing apparatus. The thermistor 36 is arranged in series with the sense lead 32 of the first Kelvin connector. Since the current lead 33 and the sense lead 32 effectively form a short circuit at the post 30. the resistance of the thermistor 36 can be calculated. The temperature sensing means comprises calculating means which measures the current induced in the sense lead 32 and the voltage drop across the thermistor 36.

Figure 6 shows an example of a mechanical connection of a temperature dependent resistor, or thermistor 36, with the thermistor 36 in thermal connection with the push-fit connector 24 and in series electrical connection with the sense lead 32.

Similarly, Figure 7 shows how this connector 24 would attach to the battery post 30, in this case a bolt, perpendicular to the battery case 40, bringing the thermistor 36 into thermal connection with the post 30 itself.

The current carrying lead attaches to another tab washer (not shown) on the same post 30.

In the above illustration the ends of both leads 32 and 33 (34 and 35) of the positive (or negative) Kelvin connection are now effectively shortened by the post 30, (31)/washer 20 junction, via the thermistor 36.

Figure 8 shows how in the present invention the two Kelvin leads may now be used to measure the temperature of the battery 18 and an electrical parameter of the battery, via the posts 30, 31.

As shown in Figure 8, a transistor 52 is used to draw a current from the battery 18 through the thermistor 36 in the sense lead 32 to ground (battery negative). For the purpose of calculation, this current may be measured across the current limiting resistor 50, or assumed as a constant, since the measured temperature may be calibrated at manufacture.

The potential difference across the thermistor 36 via the existing current leads 33 and sense leads 32 will be measured by the Analogue to Digital Converter (ADC) 56 and may be stored for calculation purposes in the microprocessor 58.

Since the current carrying Kelvin lead 33 and the signal sensing Kelvin lead 32 are effectively a short circuit at the battery post 30, the resistance of the thermistor 36 may be calculated within the processor 58 from the current induced in the sense lead 32 by the transistor 52 and the voltage drop across the thermistor 36.

The voltage drop across thermistor 36 will vary directly in accordance with the temperature of the post 30.

In the present invention, the two wires 32 and 33 of an existing Kelvin connector are used to calculate the internal temperature of a cell or battery 18, without any additional connections or wiring external to the measuring instrument or system.

The present invention however uses only the two existing Kelvin connectors each having the two usual leads themselves, and not a third or more dedicated lead(s) to acquire the post temperature.

As shown in Figure 10, in an alternative embodiment the apparatus 17 may comprise a first thermistor 36 in the first Kelvin connection and a second thermistor 37 in the second Kelvin connection.

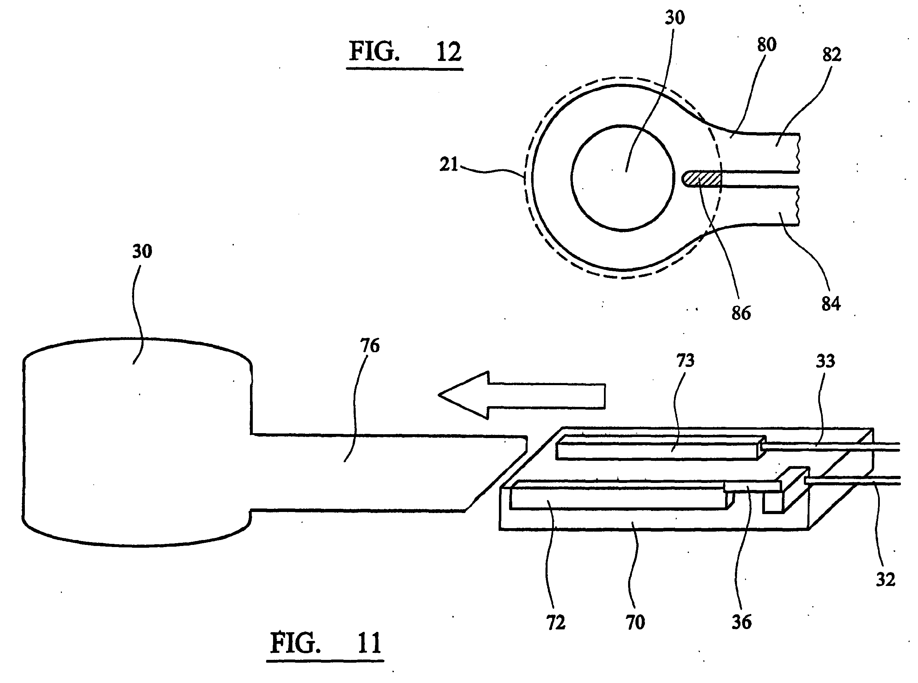

As shown in Figure 11, the first connection means may comprise a single push fit connector 70 which is arranged to be secured to a single spade tab 76 provided on a contact 30 of the battery 18. The single push fit connector 70 provides a first connecting (conducting) portion 72 or surface associated with the sense lead 32 and a second connecting (conducting) portion 73 or surface associated with the current lead 33. Again, a thermistor 36 is provided in series along the sense lead 32. The tab 76 may be attached to the post 30 or may be provided on a tab washer. In this embodiment, only a single ended connector 70 is required to be secured to each contact 30, 31 of the battery 18. The second connection means may be the same as the first connection means apart from the thermistor.

As shown in Figure 12, a tab washer 89 may comprise a first tab 82 and a second tab 84 in order for both the first (push fit) connector and the second (push fit) connector of the or each Kelvin connector to be secured to respective contact 30 of the battery 18. The use of a single washer reduces the space required along the contact 30 of the battery 18 since in some situations it may be difficult for two or more separate washers to be secured to a single contact 30, 31, for example when the contact 30, 31 is small in height. As further shown in Figure 12, the or each connecting nut 21, 23 which secures the washer 80 to the contact 30 (post) of the battery 18 is arranged to form a connection 86 (i.e. an overlapping portion) over the separating portion between the first tab 82 and the second tab 84. This is required to provide an electrical communication from the first tab 82 and the second tab 84 rather than solely a direct electrical communication from the first tab 82 to the second tab 84.

## Claims

1. Battery measuring apparatus (17) comprising temperature sensing means and electrical measuring means wherein the apparatus comprise a first connection means which is arranged, in use, to connect both the temperature sensing means and the electrical measuring means to a first contact (30) of the battery (18) and the apparatus comprises a second connection means which is arranged, in use, to connect the electrical measuring means to a second contact (31) of the battery (18), **characterised in that** the first connection means comprises a first Kelvin connector.

2. Battery measuring apparatus according to claim 1 in which the second connection means comprises a second Kelvin connector.

3. Battery measuring apparatus according to any preceding claim in which the temperature sensing means is connected using a lead of the electrical testing means.

4. Battery measuring apparatus according to any preceding claim in which the electrical measuring means is arranged to measure an electrical parameter of the battery.

5. Battery measuring apparatus according to claim 2 in which the first Kelvin connector comprises a first push fit connector (24, 70) and the second Kelvin connector comprises a second push fit connector.

6. Battery measuring apparatus according to claim 5 in which the first push fit connector (24) is arranged, in use, to be secured to a first tab (82) provided on a first contact (30) of the battery (18) and the second push fit connector (24) is arranged, in use, to be secured to a second tab (84) provided on a first contact of the battery.

7. Battery measuring apparatus according to claim 2 in which the first Kelvin connector comprises a first push fit connector (24, 70) and the second Kelvin connector comprises a second push fit connector (24, 70).

8. Battery measuring apparatus according to claim 7 in which the first push fit connector (24) is arranged, in use, to be secured to a first tab (82) provided on a second contact (31) of the battery and the second push fit connector (24) is arranged, in use, to be secured to a second tab (84) provided on a second contact (31) of the battery.

9. Battery measuring apparatus according to any preceding claim in which the temperature sensing means is arranged, in use, to be in thermal contact (or communication, for example through conduction) with a first contact of the battery.

10. Battery measuring apparatus according to any preceding claim in which the temperature sensing means is arranged to indicate or measure the core temperature of the battery.

11. Battery measuring apparatus according to any preceding claim in which the temperature sensing means comprises a thermistor (36).

12. Battery measuring apparatus according to any preceding claim in which the battery measuring apparatus is arranged to continuously measure an electrical parameter or characteristic of the battery and is arranged to continuously sense and/or measure the temperature of the battery.

13. Battery measuring apparatus according to any preceding claim wherein the first Kelvin connector comprises a sense lead (32) and a current lead (33) and wherein the temperature sensing means is connected along a lead (32, 33) of the first Kelvin connector.

14. An assembly comprising a battery measuring apparatus according to any preceding claim and a battery.

15. A method of measuring the temperature of a battery (18) comprising securing a first Kelvin connector of an electrical measuring apparatus (17) to a first contact (30) of the battery (18) and securing a second connector to a second contact (31) of the battery (18) and measuring the temperature of the battery and wherein the measuring apparatus comprises temperature sensing means and electrical measuring means, **characterised in that** the first Kelvin connector connects both the temperature sensing means and the electrical measuring means to the first contact of the battery.

16. A method according to claim 15 in which the method simultaneously measures the temperature and an electrical parameter or characteristic of the battery.

17. A method according to claim 15 or claim 16 in which the method comprises measuring the impedance and/or current and/or voltage of the battery.

18. A method according to any one of claims 15 to 17 in which the method comprises connecting only two leads (32, 33) to the first contact (30) of the battery and only two leads (34, 35) to the second contact (31) of the battery in order to measure both the temperature of the battery and en electrical measurement of the battery.

## Patentansprüche

1. Batteriemessvorrichtung (17), umfassend Temperaturfühlmittel und elektrische Messmittel, wobei die Vorrichtung ein erstes Verbindungsmittel umfasst, welches bei Verwendung so angeordnet ist, dass es sowohl das Temperaturfühlmittel als auch die elektrischen Messmittel mit einem ersten Kontakt (30) der Batterie (18) verbindet, und die Vorrichtung ein zweites Verbindungsmittel umfasst, welches bei Verwendung so angeordnet ist, dass es die elektrischen Messmittel mit einem zweiten Kontakt (31) der Batterie (18) verbindet, **dadurch gekennzeichnet, dass** das erste Verbindungsmittel einen ersten Kelvin-Steckverbinder umfasst.

2. Batteriemessvorrichtung nach Anspruch 1, wobei das zweite Verbindungsmittel einen zweiten Kelvin-Steckverbinder umfasst.

3. Batteriemessvorrichtung nach einem der vorhergehenden Ansprüche, wobei das Temperaturfühlmittel unter Verwendung einer Leitung des elektrischen Prüfmittels angeschlossen ist.

4. Batteriemessvorrichtung nach einem der vorhergehenden Ansprüche, wobei das elektrische Messmittel so ausgelegt ist, dass es einen elektrischen Parameter der Batterie misst.

5. Batteriemessvorrichtung nach Anspruch 2, wobei der erste Kelvin-Steckverbinder einen ersten Schiebepass-Steckverbinder (24, 70) umfasst, und der zweite Kelvin-Steckverbinder einen zweiten Schiebepass-Steckverbinder umfasst.

6. Batteriemessvorrichtung nach Anspruch 5, wobei der erste Schiebepass-Steckverbinder (24) bei Verwendung so angeordnet ist, dass er an einer ersten Lasche (82) gesichert ist, die auf einem ersten Kontakt (30) der Batterie (18) vorgesehen ist, und der zweite Schiebepass-Steckverbinder (24) bei Verwendung so angeordnet ist, dass er an einer zweiten Lasche (84) gesichert ist, die auf einem ersten Kontakt der Batterie vorgesehen ist.

7. Batteriemessvorrichtung nach Anspruch 2, wobei der erste Kelvin-Steckverbinder einen ersten Schiebepass-Steckverbinder (24, 70) umfasst, und der zweite Kelvin-Steckverbinder einen zweiten Schiebepass-Steckverbinder (24, 70) umfasst.

8. Batteriemessvorrichtung nach Anspruch 7, wobei der erste Schiebepass-Steckverbinder (24) bei Verwendung so angeordnet ist, dass er an einer ersten Lasche (82) gesichert ist, die auf einem zweiten Kontakt (31) der Batterie (18) vorgesehen ist, und der zweite Schiebepass-Steckverbinder (24) bei Verwendung so angeordnet ist, dass er an einer zweiten Lasche (84) gesichert ist, die auf einem zweiten Kontakt (31) der Batterie vorgesehen ist.

9. Batteriemessvorrichtung nach einem der vorhergehenden Ansprüche, wobei das Temperaturfühlmittel bei Verwendung so angeordnet ist, dass es in Wärmekontakt (oder -kommunikation, zum Beispiel durch Leitung) mit einem ersten Kontakt der Batterie ist.

10. Batteriemessvorrichtung nach einem der vorhergehenden Ansprüche, wobei das Temperaturfühlmittel so ausgelegt ist, dass es die Kerntemperatur der Batterie anzeigt oder misst.

11. Batteriemessvorrichtung nach einem der vorhergehenden Ansprüche, wobei das Temperaturfühlmittel einen Thermistor (36) umfasst.

12. Batteriemessvorrichtung nach einem der vorhergehenden Ansprüche, wobei die Batteriemessvorrichtung so ausgelegt ist, dass sie kontinuierlich einen elektrischen Parameter oder eine elektrische Eigenschaft der Batterie misst, und so ausgelegt ist, dass sie kontinuierlich die Temperatur der Batterie abfühlt und/oder misst.

13. Batteriemessvorrichtung nach einem der vorhergehenden Ansprüche, wobei der erste Kelvin-Steckverbinder eine Abfühlleitung (32) und eine Stromleitung (33) umfasst, und wobei das Temperaturfühlmittel entlang einer Leitung (32, 33) des ersten Kelvin-Steckverbinders angeschlossen ist.

14. Anordnung, umfassend eine Batteriemessvorrichtung nach einem der vorgehenden Ansprüche und eine Batterie.

15. Verfahren zum Messen der Temperatur einer Batterie (18), umfassend ein Sichern eines ersten Kelvin-Steckverbinders einer elektrischen Messvorrichtung (17) an einem ersten Kontakt (30) der Batterie (18) und Sichern eines zweiten Steckverbinders an einem zweiten Kontakt (31) der Batterie (18) und Messen der Temperatur der Batterie, und wobei die Messvorrichtung Temperaturfühlmittel und elektrische Messmittel umfasst, **dadurch gekennzeichnet, dass** der erste Kelvin-Steckverbinder sowohl die Temperaturfühlmittel als auch die elektrischen Messmittel mit dem ersten Kontakt der Batterie verbindet.

16. Verfahren nach Anspruch 15, wobei das Verfahren gleichzeitig die Temperatur und einen elektrischen Parameter oder eine elektrische Eigenschaft der Batterie misst.

17. Verfahren nach Anspruch 15 oder 16, wobei das Verfahren ein Messen der Impedanz und/oder des Stroms und/oder der Spannung der Batterie umfasst.

18. Verfahren nach einem der Ansprüche 15 bis 17, wobei das Verfahren ein Anschließen von nur zwei Leitungen (32, 33) an den ersten Kontakt (30) der Batterie und von nur zwei Leitungen (34, 35) an den zweiten Kontakt (31) der Batterie umfasst, um sowohl die Temperatur der Batterie zu messen als auch eine elektrische Messung der Batterie vorzunehmen.

## Revendications

1. Dispositif de mesure de batterie (17) comprenant des moyens de détection de température et des moyens de mesure électriques, dans lequel le dispositif comprend un premier moyens de connexion qui est agencé, en utilisation, pour connecter à la fois les moyens de détection de température et les moyens de mesure électriques à un premier contact (30) de la batterie (18) et le dispositif comprend un deuxième moyens de connexion qui est agencé, en utilisation, pour connecter les moyens de mesure électriques à un deuxième contact (31) de la batterie (18), **caractérisé en ce que** le premier moyens de connexion comprend un premier connecteur Kelvin.

2. Dispositif de mesure de batterie selon la revendication 1, dans lequel le deuxième moyens de connexion comprend un deuxième connecteur Kelvin.

3. Dispositif de mesure de batterie selon l'une quelconque des revendications précédentes, dans lequel les moyens de détection de température sont connectés en utilisant un conducteur des moyens de test électriques.

4. Dispositif de mesure de batterie selon l'une quelconque des revendications précédentes, dans lequel les moyens de mesure électriques sont agencés pour mesurer un paramètre électrique de la batterie.

5. Dispositif de mesure de batterie selon la revendication 2, dans lequel le premier connecteur Kelvin comprend un premier connecteur à assemblage par pression (24, 70) et le deuxième connecteur Kelvin comprend un deuxième connecteur à assemblage par pression.

6. Dispositif de mesure de batterie selon la revendication 5, dans lequel le premier connecteur à assemblage par pression (24) est agencé, en utilisation, pour être fixé à une première languette (82) fournie sur un premier contact (30) de la batterie (18) et le deuxième connecteur à assemblage par pression (24) est agencé, en utilisation, pour être fixé à une deuxième languette (84) fournie sur un premier contact de la batterie.

7. Dispositif de mesure de batterie selon la revendication 2, dans lequel le premier connecteur Kelvin comprend un premier connecteur à assemblage par pression (24, 70) et le deuxième connecteur Kelvin comprend un deuxième connecteur à assemblage par pression (24, 70).

8. Dispositif de mesure de batterie selon la revendication 7, dans lequel le premier connecteur à assemblage par pression (24) est agencé, en utilisation, pour être fixé à une première languette (82) fournie sur un deuxième contact (31) de la batterie et le deuxième connecteur à assemblage par pression (24) est agencé, en utilisation, pour être fixé à une deuxième languette (84) fournie sur un deuxième contact (31) de la batterie.

9. Dispositif de mesure de batterie selon l'une quelconque des revendications précédentes, dans lequel les moyens de détection de température sont agencés, en utilisation, pour être en contact thermique (ou en communication, par exemple par conduction) avec un premier contact de la batterie.

10. Dispositif de mesure de batterie selon l'une quelconque des revendications précédentes, dans lequel les moyens de détection de température sont agencés pour indiquer ou mesurer la température à coeur de la batterie.

11. Dispositif de mesure de batterie selon l'une quelconque des revendications précédentes, dans lequel les moyens de détection de température comprennent une thermistance (36).

12. Dispositif de mesure de batterie selon l'une quelconque des revendications précédentes, dans lequel le dispositif de mesure de batterie est agencé pour mesurer en continu un paramètre ou une caractéristique électrique de la batterie et est agencé pour détecter et/ou mesurer en continu la température de la batterie.

13. Dispositif de mesure de batterie selon l'une quelconque des revendications précédentes, dans lequel le premier connecteur Kelvin comprend un conducteur de détection (32) et un conducteur de courant (33), et dans lequel les moyens de détection de température sont connectés le long d'un conducteur (32, 33) du premier connecteur Kelvin.

14. Ensemble comprenant un dispositif de mesure de batterie selon l'une quelconque des revendications précédentes et une batterie.

15. Procédé de mesure de la température d'une batterie (18) comprenant à fixer un premier connecteur Kelvin d'un dispositif de mesure électrique (17) à un premier contact (30) de la batterie (18) et fixer un deuxième connecteur à un deuxième contact (31) de la batterie (18) et mesurer la température de la batterie, et dans lequel le dispositif de mesure comprend des moyens de détection de température et des moyens de mesure électriques, **caractérisé en ce que** le premier connecteur Kelvin connecte à la fois les moyens de détection de température et les moyens de mesure électriques au premier contact de la batterie.

16. Procédé selon la revendication 15, dans lequel le procédé mesure simultanément la température et un paramètre ou une caractéristique électrique de la batterie.

17. Procédé selon la revendication 15 ou la revendication 16, dans lequel le procédé comprend la mesure de l'impédance et/ou du courant et/ou de la tension de la batterie.

18. Procédé selon l'une quelconque des revendications 15 à 17, dans lequel le procédé consiste à connecter seulement deux conducteurs (32, 33) au premier contact (30) de la batterie et seulement deux conducteurs (34, 35) au deuxième contact (31) de la batterie afin d'effectuer à la fois une mesure de la température de la batterie et une mesure électrique de la batterie.
